# FASCICULE DE BREVET EUROPEEN

(11) **EP 3 903 341 B1**
(45) Date de publication et mention de la délivrance du brevet: **18.01.2023**
(21) Numéro de dépôt: 19848983.3
(22) Date de dépôt: 23.12.2019
(51) Int. Cl.: H01L 21/762, H01L 21/322, H01L 21/265

(54) **PROCEDE DE FABRICATION D'UN SUBSTRAT POUR UN CAPTEUR D'IMAGE DE TYPE FACE AVANT**
VERFAHREN ZUR HERSTELLUNG EINES SUBSTRATS FÜR EINEN VORDERSEITIGEN BILDSENSOR
METHOD FOR MANUFACTURING A SUBSTRATE FOR A FRONT-FACING IMAGE SENSOR

(30) Priorité: 24.12.2018 FR 1874134
(43) Date de publication de la demande: 03.11.2021
(73) Titulaire: SOITEC, 38190 Bernin (FR)
(72) Inventeur: SCHWARZENBACH, Walter, 38330 SAINT NAZAIRE LES EYMES (FR); ECARNOT, Ludovic, 38000 GRENOBLE (FR); MASSY, Damien, 38300 SAINT ISMIER (FR); BEN MOHAMED, Nadia, 38130 ECHIROLLES (FR); DAVAL, Nicolas, 38570 GONCELIN (FR); GIRARD, Christophe, 38570 THEYS (FR); MALEVILLE, Christophe, 38660 LUMBIN (FR)
(74) Mandataire: Regimbeau
(86) Numéro de dépôt international: PCT/FR2019/053281
(87) Numéro de publication internationale: WO 2020/136344

(56) Documents cités:
- US-A- 6 083 324
- US-A1- 2010 090 303

## Description

### DOMAINE DE L'INVENTION

La présente invention concerne un procédé de fabrication d'un substrat pour un capteur d'image de type face avant.

### ETAT DE LA TECHNIQUE

Les structures de type semi-conducteur sur isolant, et notamment les substrats de type silicium sur isolant (connus sous l'acronyme SOI du terme anglo-saxon « Silicon On Insulator ») sont des substrats intéressants pour la fabrication de capteurs d'image de type face avant.

Un substrat SOI présente, de sa face arrière vers sa face avant, un substrat support de silicium présentant un certain dopage, une couche d'oxyde de silicium dite « couche d'oxyde enterrée » (souvent désignée par l'acronyme BOX, du terme anglo-saxon « Buried OXide »), et une couche dite couche active de silicium présentant un dopage pouvant être différent de celui du substrat support. Un réseau matriciel de photodiodes définissant chacune un pixel du capteur d'image est agencé dans la couche active.

Dans certaines applications, la couche d'oxyde enterrée est choisie relativement mince (c'est-à-dire présentant une épaisseur inférieure à 100 nm, notamment de l'ordre de 20 à 50 nm) pour remplir la fonction du diélectrique d'un condensateur en permettant une polarisation par la face arrière du pixel. La partie du substrat support située sous la couche d'oxyde enterrée est polarisée à une tension électrique différente de celle de la couche active, ce qui permet de passiver l'interface entre la couche diélectrique et la couche active. La tension électrique à appliquer à la partie du substrat support située sous la couche d'oxyde enterrée dépend de l'épaisseur de cette dernière. La différence de potentiel à appliquer est d'autant plus faible que la couche d'oxyde enterrée est mince.

Une autre fonction de cette couche d'oxyde enterrée est de prévenir la collection de signal parasite dû à la recombinaison dans le substrat support de photons non absorbés durant leur parcours dans chaque pixel (prévention du « crosstalk », selon le terme anglo-saxon convenu), étant entendu que la couche d'oxyde enterrée peut, selon l'épaisseur choisie, n'être que partiellement réflective et/ou absorbante pour les photons incidents.

Un inconvénient des procédés pour la fabrication de capteurs d'image est leur grande sensibilité à la contamination par des métaux. Le substrat SOI en lui-même tout comme le pixel peuvent en effet se trouver exposés à des métaux au cours de leurs procédés de fabrication. Cette exposition se traduit notamment par la présence d'atomes métalliques au sein de la couche active. Or, même une faible concentration en atomes métalliques, notamment en atomes de cuivre, peut se traduire par une perte de performance rédhibitoire du capteur d'image. En effet, les atomes métalliques sont susceptibles d'interagir avec les charges électriques générées par les photons capturés dans les pixels et de dégrader leurs performances de collecte.

Pour limiter cet inconvénient, il est connu de former au sein du substrat SOI une couche de piégeage des atomes métalliques.

Le document US 6,083,324 décrit ainsi la formation d'une couche de piégeage dans la couche active du substrat SOI, par implantation d'ions d'espèces gazeuses, puis mise en oeuvre d'un traitement thermique adapté pour former, à partir des ions implantés, des microbulles ou des précipités. Ces microbulles ou précipités forment des sites de piégeage pour des atomes métalliques. Cependant, cette couche de piégeage, de par sa nature de cavités et les interfaces qu'elle créée dans le pixel, est susceptible de perturber la trajectoire des photons dans les pixels et de dégrader les performances électriques du capteur d'image.

Le document US 2010/0090303 décrit la formation d'une couche de piégeage dans le substrat support. Plus précisément, lorsque le substrat SOI est formé par un transfert de couche de type Smart Cut^{™}, le procédé de fabrication du substrat SOI comprend les étapes suivantes :
- fourniture d'un substrat donneur de silicium recouvert d'une couche d'oxyde de silicium destinée à former le BOX et comprenant une zone de fragilisation délimitant une couche mince de silicium ;
- fourniture d'un substrat support dans lequel la couche de piégeage a été formée par implantation d'ions ;
- collage du substrat donneur et du substrat support par l'intermédiaire de la couche d'oxyde ;
- détachement du substrat donneur le long de la zone de fragilisation, de sorte à transférer la couche mince de silicium et la couche d'oxyde sur le substrat support ;
- croissance épitaxiale d'une couche supplémentaire de silicium sur la couche mince transférée, jusqu'à l'obtention de l'épaisseur souhaitée pour la couche active du capteur d'image.

Cependant, l'état de surface du substrat support ayant subi l'implantation des ions destinés à former la couche de piégeage est d'une qualité insuffisante pour assurer une bonne tenue du collage lorsque la couche d'oxyde enterrée est très fine, ce qui représente un inconvénient notable de ce procédé, en particulier dans le cadre du collage d'oxydes minces tels que ceux visés pour un capteur d'image proche infrarouge par la face avant.

### EXPOSE DE L'INVENTION

Il subsiste donc un besoin de former une zone de piégeage dans le substrat support d'une structure de type semi-conducteur sur isolant destinée à former un capteur d'image de type face avant, tout en garantissant une bonne adhésion de la couche active vis-à-vis du substrat support.

A cet effet, l'invention propose un procédé de fabrication d'un substrat pour capteur d'image de type face avant, comprenant :
la fourniture d'un substrat donneur (30), comprenant une couche semi-conductrice à transférer,
   la fourniture d'un substrat support semi-conducteur,
le collage du substrat donneur sur le substrat support, une couche électriquement isolante étant à l'interface de collage,
le transfert de la couche semi-conductrice sur le substrat support,
l'implantation d'ions gazeux dans le substrat support au travers de la couche semi-conductrice transférée et de la couche électriquement isolante,
après ladite implantation, la croissance épitaxiale d'une couche semi-conductrice additionnelle sur la couche semi-conductrice transférée.

De manière avantageuse, ledit procédé comprend un traitement thermique réalisé à une température adaptée pour provoquer le développement de cavités à partir des ions gazeux implantées, lesdites cavités formant une couche de piégeage d'atomes métalliques dans le substrat support.

Selon un mode de réalisation, ledit traitement thermique est mis en oeuvre lors de la croissance épitaxiale de la couche semi-conductrice additionnelle.

De préférence, la densité de cavités dans la couche de piégeage est supérieure ou égale à 10¹⁵ cavités/cm³.

Selon une forme d'exécution, chaque couche semi-conductrice est une couche de silicium.

Selon un mode de réalisation, la couche électriquement isolante est une couche d'oxyde de silicium.

De manière alternative, la couche électriquement isolante est constituée d'un empilement de matériaux diélectriques et/ou métalliques.

De préférence, la couche électriquement isolante présente une épaisseur comprise entre 5 et 400 nm, de préférence entre 30 et 150 nm.

De manière préférée, les ions gazeux comprennent des ions hélium.

Selon un mode de réalisation, le transfert de la couche semi-conductrice comprend :
- la formation d'une zone de fragilisation dans le substrat donneur pour délimiter ladite couche semi-conductrice à transférer ;
- après le collage, le détachement du substrat donneur le long de la zone de fragilisation.

L'invention concerne également un procédé de fabrication d'un capteur d'image de type face avant, comprenant la fabrication d'un substrat par le procédé tel que décrit ci-dessus, la couche semi-conductrice transférée et la couche semi-conductrice additionnelle formant ensemble une couche active dudit capteur d'image, et la formation, dans ladite couche active, d'une pluralité de tranchées électriquement isolantes pour délimiter une pluralité de pixels.

### BREVE DESCRIPTION DES FIGURES

D'autres caractéristiques et avantages de l'invention ressortiront de la description détaillée qui va suivre, en référence aux dessins annexés sur lesquels :
- la figure 1A est une vue en coupe d'un substrat SOI pour capteur d'image selon un mode de réalisation de l'invention ;
- la figure 1B est une vue en coupe d'un substrat selon une variante de la figure 1A ;
- la figure 2 illustre de manière schématique l'implantation d'espèces atomiques dans un substrat donneur pour y former une zone de fragilisation délimitant une couche semi-conductrice à transférer ;
- la figure 3 illustre de manière schématique le collage du substrat donneur fragilisé de la figure 2 sur un substrat support ;
- la figure 4 illustre de manière schématique le transfert de la couche semi-conductrice sur le substrat support de sorte à former une structure SOI ;
- la figure 5 illustre de manière schématique l'implantation d'hélium dans la structure SOI de la figure 4 ;
- la figure 6 illustre le substrat obtenu après formation de tranchées électriquement isolantes dans le substrat de la figure 1 pour individualiser chaque pixel du capteur d'image ; le dit substrat ayant subi au préalable une étape de re-épitaxie ;
- la figure 7 présente des images d'une coupe du substrat de la figure 5 par un microscope électronique en transmission (l'image de droite étant un grossissement de l'image de gauche) ;
- la figure 8 est une image par un microscope électronique en transmission d'une coupe du substrat de la figure 5 après un traitement thermique supplémentaire appliqué au substrat par rapport aux images de la figure 7 ;
- la figure 9 présente une mesure par spectrométrie de masse d'ions secondaires (SIMS) de la concentration du cuivre illustrant sa diffusion au sein du substrat de la figure 5, superposée à une image par un microscope électronique en transmission d'une coupe dudit substrat ;
- la figure 10 présente une mesure SIMS de la concentration du cuivre illustrant sa diffusion au sein d'un substrat du type de celui de la figure 5 mais ne comprenant pas de couche de piégeage ;
- la figure 11 présente une mesure SIMS de la concentration du cuivre illustrant sa diffusion au sein du substrat de la figure 5.

Pour des raisons de lisibilité des figures, les différentes couches ne sont pas représentées à l'échelle. Les signes de référence identiques d'une figure à l'autre désignent des éléments identiques ou remplissant la même fonction.

### DESCRIPTION DETAILLEE DE MODES DE REALISATION DE L'INVENTION

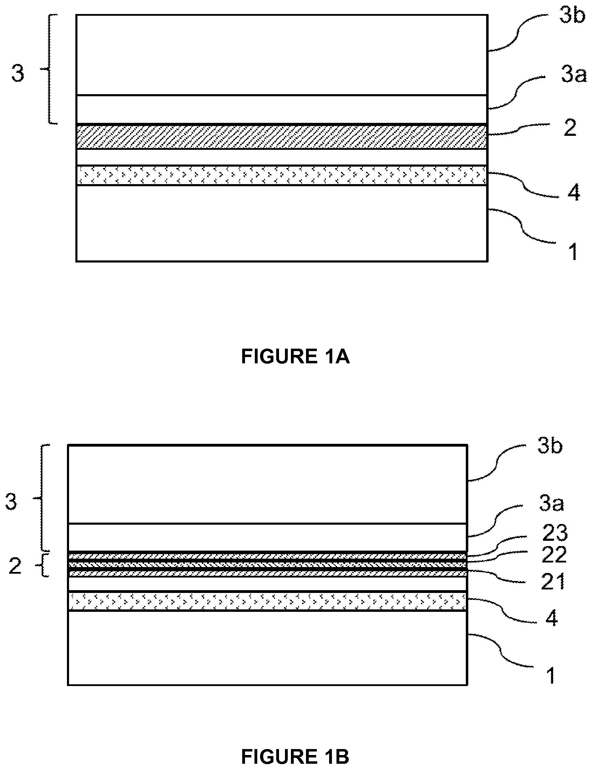

La figure 1A illustre un substrat SOI pour capteur d'image selon un mode de réalisation de l'invention.

Ledit substrat comprend successivement, de sa face arrière vers sa face avant, un substrat support 1, une couche électriquement isolante 2 et une couche semi-conductrice 3, dite couche active, destinée à la formation des pixels du capteur d'image.

Une couche 4 de piégeage d'atomes métalliques est agencée à une certaine profondeur du substrat support 1, non nécessairement en contact avec la couche électriquement isolante 2. Comme cela sera décrit en détail plus bas, ladite couche 4 comprend des cavités qui se sont développées à partir d'ions gazeux implantés dans le substrat support sous l'effet d'un traitement thermique. La densité de cavités dans ladite couche de piégeage 4 est avantageusement supérieure ou égale à 10¹⁵ cavités/cm³. Lesdites cavités permettent de capter les atomes métalliques présents dans le substrat SOI au voisinage de la couche électriquement isolante 2, qui peuvent altérer le bon fonctionnement du capteur. Ces atomes peuvent être présents initialement dans le substrat support 1 et/ou dans la couche active 3, et diffuser dans le substrat SOI sous l'effet de traitements thermiques, jusqu'à la couche de piégeage 4 où ils sont captés.

Le substrat support est avantageusement un substrat de silicium, notamment monocristallin.

La couche électriquement isolante 2 peut être une couche d'oxyde de silicium, qui est un isolant classique dans le domaine des substrats de type silicium sur isolant.

De manière alternative, la couche électriquement isolante peut être constituée d'un empilement de différents matériaux diélectriques et/ou métalliques, tel qu'un empilement dit « ONO », c'est-à-dire oxyde-nitrure-oxyde. Les matériaux constituant ledit empilement sont avantageusement choisis de sorte à augmenter la réflectivité de la couche électriquement isolante dans l'infrarouge, par rapport à une couche d'oxyde de silicium de même épaisseur totale. De préférence, une couche métallique est encapsulée entre deux couches diélectriques qui évitent ainsi toute contamination métallique de la couche active. On évite ainsi la génération de défauts électriques à l'interface entre la couche active et la couche électriquement isolante et des recombinaisons entre le matériau semi-conducteur de la couche active et les composants métalliques du capteur d'image, susceptibles de doper la couche active.

Selon un mode de réalisation particulier illustré sur la figure 1B, la couche électriquement isolante 2 comprend une couche 22 de nitrure de silicium entre deux couches 21, 23 d'oxyde de silicium. La couche 21 qui est agencée du côté du substrat support 1 présente une épaisseur comprise entre 50 et 500 nm, la couche 23 qui est agencée du côté de la couche active 3 présente une épaisseur comprise entre 5 et 50 nm, et la couche 22 une épaisseur comprise entre 10 et 100 nm. Une telle couche électriquement isolante présente l'avantage de réfléchir davantage les photons transmis au travers de la couche active 3 qu'une couche d'oxyde de silicium d'épaisseur identique du substrat de la figure 1A.

De manière particulièrement avantageuse, qu'elle soit constituée d'un ou plusieurs matériaux, la couche électriquement isolante 2 est mince, c'est-à-dire qu'elle présente une épaisseur comprise entre 5 et 400 nm, de préférence entre 30 et 150 nm. Une telle couche ne forme pas de barrière à la diffusion des atomes métalliques, notamment de cuivre. Il n'est donc pas nécessaire, comme dans le document US 2010/0090303, d'endommager localement la couche électriquement isolante pour permettre le passage des atomes.

La couche active est avantageusement monocristalline. Comme cela est schématisé sur la figure 1, la couche active 3 est formée par empilement d'une première couche 3a et d'une couche additionnelle 3b, la couche 3b étant fabriquée par épitaxie sur la couche 3a qui sert alors de couche germe. Les matériaux des couches 3a et 3b présentent avantageusement des paramètres de maille et des coefficients de dilatation thermique proches qui permettent de minimiser la formation de défauts cristallins au sein de la couche 3b lors de sa croissance épitaxiale. Selon un mode de réalisation préféré, les couches 3a et 3b sont constituées du même matériau, typiquement du silicium ou encore du silicium-germanium. Les couches 3a et/ou 3b peuvent éventuellement être dopées.

L'épaisseur de la couche 3 est typiquement supérieure ou égale à 1 µm.

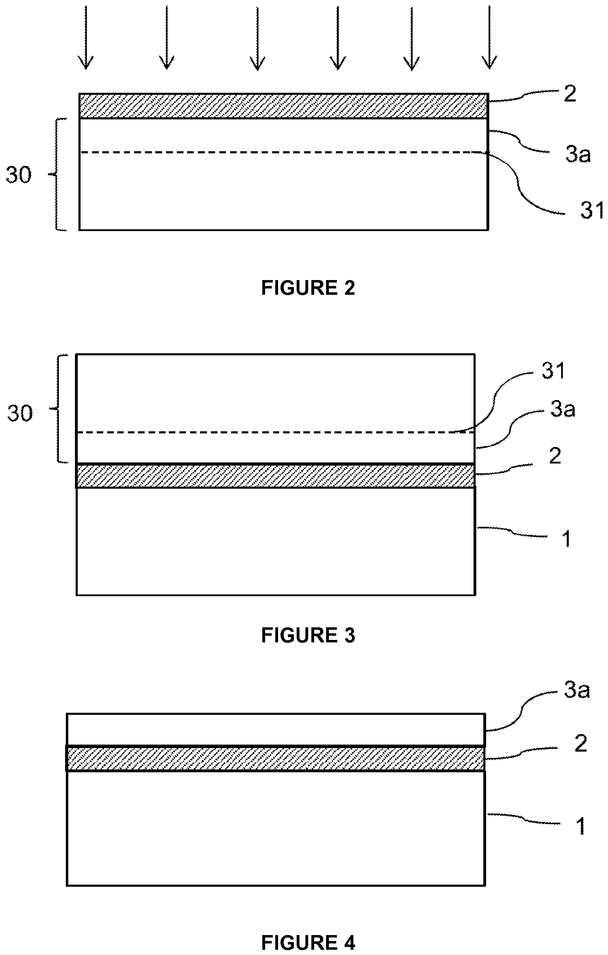

On va maintenant décrire, en référence aux figures 2 à 5, un procédé de fabrication du substrat de la figure 1A basé sur le procédé Smart Cut^{™}.

En référence à la figure 2, on fournit un substrat donneur 30 recouvert de la couche électriquement isolante 2. La couche électriquement isolante peut être formée par oxydation thermique du matériau du substrat donneur, et/ou par dépôt d'une ou plusieurs couches diélectriques et/ou métalliques. On forme par implantation d'espèces atomiques (schématisée par les flèches) une zone de fragilisation dans le substrat donneur 30, qui délimite la couche semi-conductrice 3a à transférer. Les espèces atomiques implantées à cet effet comprennent avantageusement de l'hydrogène et/ou de l'hélium.

En référence à la figure 3, on colle le substrat donneur 30 sur le substrat support 1, la couche électriquement isolante 2 étant à l'interface de collage.

En référence à la figure 4, on détache le substrat donneur 30 le long de la zone de fragilisation 31, de sorte à transférer la couche semi-conductrice 3a sur le substrat support 1.

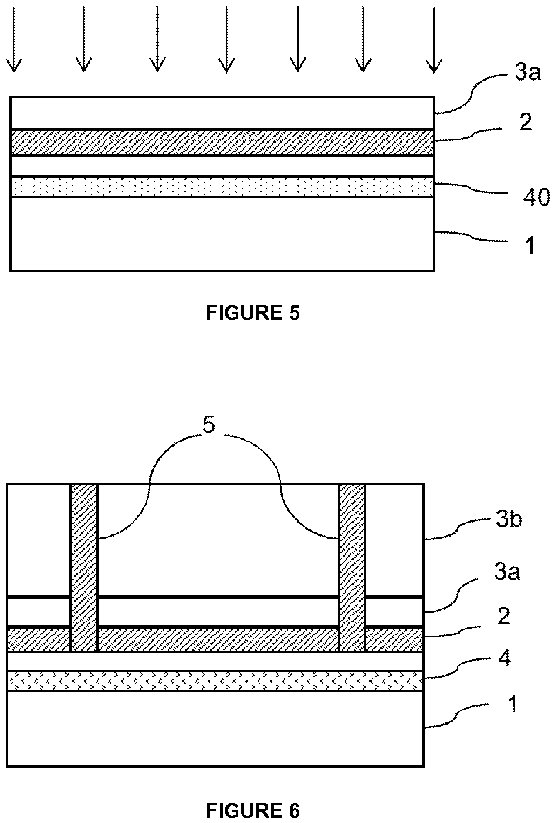

En référence à la figure 5, on implante dans le substrat support 1 des ions gazeux (par exemple de l'hélium) au travers de la couche semi-conductrice 3a et de la couche électriquement isolante 2. L'homme du métier est à même de définir les paramètres d'implantation, notamment la dose et l'énergie d'implantation pour localiser lesdits ions 40 gazeux dans une couche dans l'épaisseur du substrat support 1. A titre indicatif, une dose comprise entre 1E16 atomes/cm² et 5E17 atomes/cm² est adaptée pour obtenir une densité de cavités d'au moins 10E15 cavités/cm³. En ce qui concerne l'énergie d'implantation, elle est typiquement comprise entre quelques keV et 120 keV. L'homme du métier choisira l'énergie adaptée en fonction des épaisseurs des couches à traverser par les ions pour localiser lesdits ions dans le substrat support sous la couche électriquement isolante.

Un traitement thermique est ensuite mis en oeuvre pour développer des cavités à partir des ions gazeux implantés, de sorte à former une couche de piégeage d'atomes métalliques. D'une manière générale, ce traitement implique de porter le substrat à une température comprise entre 850 et 1200°C, pendant une durée comprise entre 30 et 180 minutes. Ce traitement thermique peut être mis en oeuvre en tant qu'étape spécifique du procédé. Cependant, il peut être avantageux d'utiliser le budget thermique d'une autre étape du procédé, par exemple une étape de finition du substrat SOI (telle qu'un recuit de lissage ou de guérison des défauts) ou l'étape d'épitaxie mise en oeuvre pour faire croître la couche semi-conductrice additionnelle 3b sur la couche transférée 3a.

En alternative au procédé Smart Cut^{™} qui vient d'être décrit, le transfert de la couche semi-conductrice peut être réalisé, après le collage du substrat donneur sur le substrat support, par un amincissement du substrat donneur par sa face opposée à l'interface de collage, par exemple par gravure, jusqu'à l'obtention de l'épaisseur souhaitée pour la couche semi-conductrice transférée. La formation de la zone de fragilisation n'est pas nécessaire dans ce cas.

Le fait que la couche de piégeage soit formée après le collage du substrat donneur sur le substrat support, et non avant comme décrit dans le document US 2010/0090303, permet d'assurer une qualité optimale des surfaces à coller et par conséquent une bonne adhésion des deux substrats, y compris lorsque la couche électriquement isolante est mince. Par ailleurs, le fait que l'implantation des ions gazeux soit réalisée avant l'épitaxie de la couche semi-conductrice additionnelle permet de minimiser l'énergie d'implantation et d'éviter d'endommager la couche active.

En référence à la figure 6, on fait croître par épitaxie la couche semi-conductrice additionnelle 3b sur la couche transférée 3a, jusqu'à l'obtention de l'épaisseur souhaitée pour la couche active 3. Comme indiqué plus haut, le budget thermique de cette épitaxie peut être mis à profit pour développer les cavités formant la couche de piégeage 4. Ensuite, on forme des tranchées au travers de la couche active 3 jusque dans la couche électriquement isolante 2, et l'on remplit lesdites tranchées 5 d'un matériau diélectrique afin d'isoler électriquement les pixels du capteur d'image.

### Résultats expérimentaux

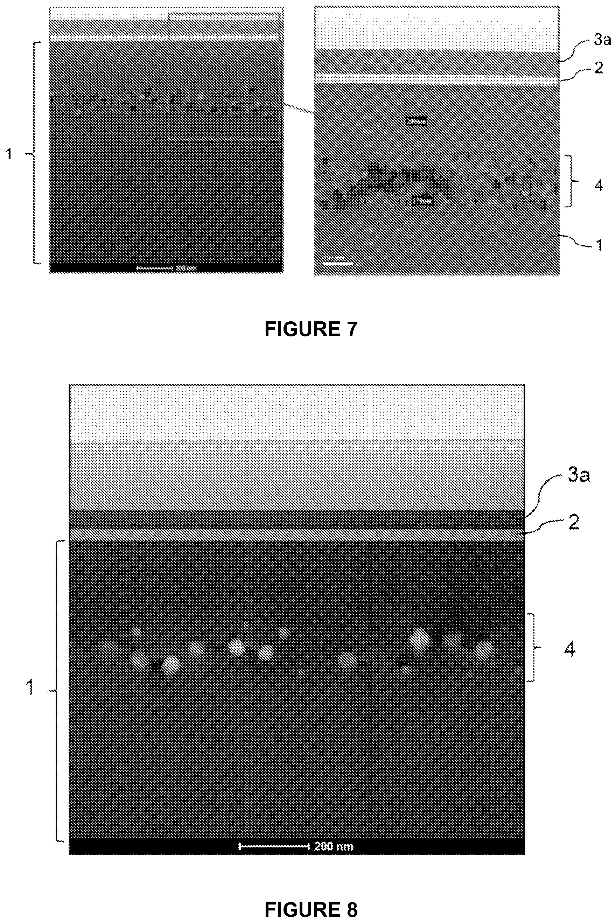

Des substrats SOI tels qu'illustrés sur la figure 5 ont été réalisés et la couche de piégeage a été formée en développant les cavités à partir des ions gazeux implantés en portant certains desdits substrats SOI à une température de 950°C pendant 40 minutes (cf. figure 7).

Lesdits substrats ont ensuite été soumis à des traitements thermiques que des substrats SOI comportant la couche de piégeage d'atomes métallique peut subir, afin de vérifier que la couche de piégeage est stable et rester fonctionnelle même après avoir subi un traitement thermique procurant un budget thermique élevé (cf. figure 8). On considère ainsi que le budget thermique d'un traitement à 1100 °C pendant 2h est un budget thermique maximal permettant de préserver les propriétés de piégeage de la couche de cavités. Ce budget thermique est compatible avec des étapes de finition et éventuellement une épitaxie.

La figure 7 présente des images d'une coupe du substrat de la figure 5 par un microscope électronique en transmission (l'image de droite étant un grossissement de l'image de gauche), après la mise en oeuvre d'un traitement thermique adapté pour développer les cavités. On observe au sein du substrat support 1 les cavités agencées selon une couche 4 formant une couche de piégeage d'atomes métalliques. Dans l'exemple illustré, la couche 4 présente une épaisseur de 179 nm et est enterrée à une profondeur de 205 nm sous l'interface entre le substrat support 1 et la couche électriquement isolante 2.

La figure 8 est une image par un microscope électronique en transmission d'une coupe du substrat de la figure 5 après un traitement thermique supplémentaire appliqué au substrat par rapport aux images de la figure 7, ledit traitement thermique étant réalisé à une température allant jusqu'à 1100°C pendant une durée inférieure ou égale à 2 heures. On observe dans l'épaisseur du substrat support 1, à la profondeur d'implantation des ions gazeux, des cavités agencées selon la couche 4 qui forme une couche de piégeage d'atomes métalliques.

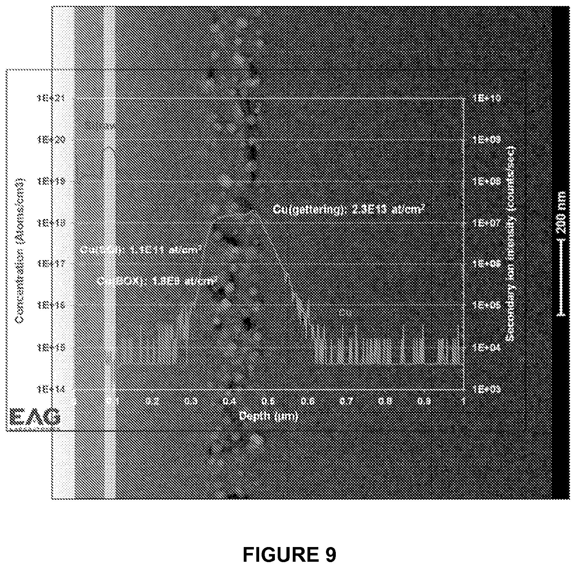

La figure 9 présente une mesure par spectrométrie de masse d'ions secondaires (SIMS) de la concentration du cuivre dans le substrat de la figure 5, superposée à une image par un microscope électronique en transmission d'une coupe dudit substrat. Pour réaliser cette mesure, une couche de cuivre a été déposée sur la couche semi-conductrice 3a et un traitement thermique (800°C pendant 2 heures) a été mis en oeuvre pour faire diffuser les atomes de cuivre au sein du substrat. Ce traitement thermique a été choisi, à des fins de démonstration, pour assurer, compte-tenu des propriétés physiques de diffusion du cuivre dans le silicium et l'oxyde de silicium, une complète dispersion de cet élément dans le matériau. Cette mesure reflète ainsi la capacité des atomes de cuivre à traverser la couche électriquement isolante 2 et à être piégés par la couche de piégeage 4. Ainsi, alors que la concentration en atomes de cuivre dans la couche 3a est de l'ordre de 1,1E11 atomes/cm³ et de l'ordre de 1,8E9 atomes/cm³ dans la couche électriquement isolante, la courbe présente un pic au niveau de la couche 4 avec une concentration en atomes de cuivre de l'ordre de 2,3E13 atomes/cm³. La concentration en atomes de cuivre sous la couche 4 est très faible.

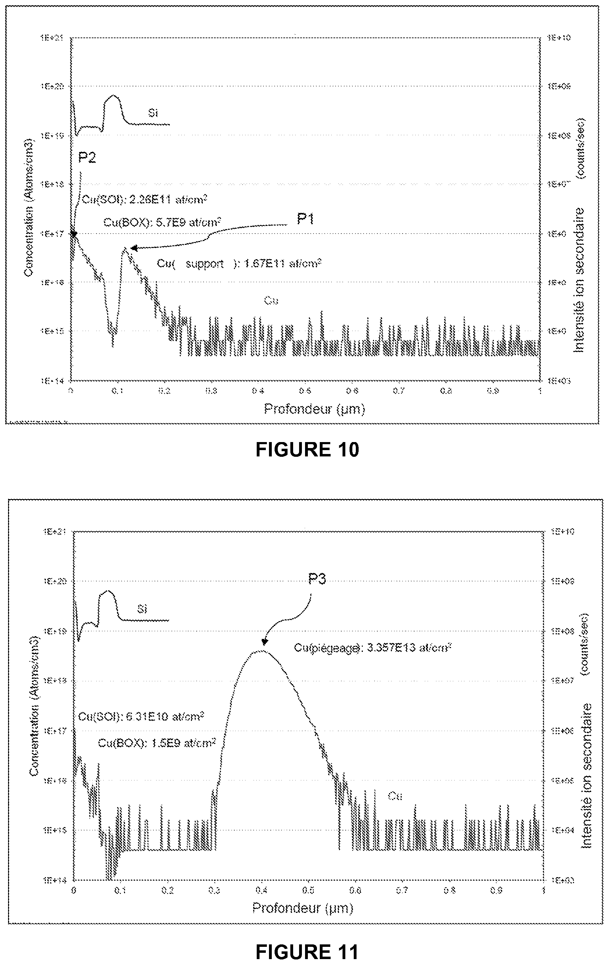

Les figures 10 et 11 présentent une mesure SIMS de la concentration du cuivre au sein d'un substrat du type de celui de la figure 5 respectivement sans et avec la couche de piégeage 4. Pour réaliser cette mesure, une couche de cuivre a été déposée sur la face arrière du substrat support 1 et un traitement thermique (800°C pendant 2 heures) a été mis en oeuvre pour faire diffuser les atomes de cuivre au sein du substrat. Dans le cas de la figure 10 (absence de couche de piégeage), on observe une forte concentration en atomes de cuivre dans le substrat support 1 sous la couche électriquement isolante (pic P1), et une forte concentration en atomes de cuivre dans la couche transférée au voisinage de la surface libre de ladite couche (pic P2). Dans le cas de la figure 11 (présence d'une couche de piégeage selon l'invention), on observe que le pic P3 de concentration en atomes de cuivre est localisé au niveau de la couche de piégeage.

### REFERENCES

US 6,083,324
US 2010/0090303

## Revendications

1. Procédé de fabrication d'un substrat pour capteur d'image de type face avant, comprenant :
- la fourniture d'un substrat donneur (30), comprenant une couche semi-conductrice (3a) à transférer,
- la fourniture d'un substrat support (1) semi-conducteur,
- le collage du substrat donneur (30) sur le substrat support (1), une couche électriquement isolante (2) étant à l'interface de collage,
- le transfert de la couche semi-conductrice (3a) sur le substrat support (1), et **caractérisé en ce que** le procédé comprend en outre les étapes consistant à :
- l'implantation d'ions gazeux (40) dans le substrat support (1) au travers de la couche semi-conductrice (3a) transférée et de la couche électriquement isolante (2),
- après ladite implantation, la croissance épitaxiale d'une couche semi-conductrice additionnelle (3b) sur la couche semi-conductrice transférée (3a).

2. Procédé selon la revendication 1, comprenant un traitement thermique réalisé à une température adaptée pour provoquer le développement de cavités à partir des ions gazeux implantées, lesdites cavités formant une couche (4) de piégeage d'atomes métalliques dans le substrat support (1).

3. Procédé selon la revendication 2, dans lequel ledit traitement thermique est mis en oeuvre lors de la croissance épitaxiale de la couche semi-conductrice additionnelle (3b).

4. Procédé selon l'une des revendications 2 ou 3, dans lequel la densité de cavités dans la couche de piégeage (4) est supérieure ou égale à 10¹⁵ cavités/cm³.

5. Procédé selon l'une des revendications 1 à 4, dans lequel chaque couche semi-conductrice (3a, 3b) est une couche de silicium.

6. Procédé selon l'une des revendications 1 à 5, dans lequel la couche électriquement isolante (2) est une couche d'oxyde de silicium.

7. Procédé selon l'une des revendications 1 à 6, dans lequel la couche électriquement isolante (2) est constituée d'un empilement (21, 22, 23) de matériaux diélectriques et/ou métalliques.

8. Procédé selon l'une des revendications 1 à 7, dans lequel la couche électriquement isolante (2) présente une épaisseur comprise entre 5 et 400 nm, de préférence entre 30 et 150 nm.

9. Procédé selon l'une des revendications 1 à 8, dans lequel les ions gazeux (40) comprennent des ions hélium.

10. Procédé selon l'une des revendications 1 à 9, dans lequel le transfert de la couche semi-conductrice (3a) comprend :
- la formation d'une zone de fragilisation (31) dans le substrat donneur pour délimiter ladite couche semi-conductrice à transférer ;
- après le collage, le détachement du substrat donneur (30) le long de la zone de fragilisation (31).

11. Procédé de fabrication d'un capteur d'image de type face avant, comprenant la fabrication d'un substrat par le procédé selon l'un des revendications 1 à 10, la couche semi-conductrice transférée (3a) et la couche semi-conductrice additionnelle (3b) formant ensemble une couche active dudit capteur d'image, et la formation, dans ladite couche active, d'une pluralité de tranchées (5) électriquement isolantes pour délimiter une pluralité de pixels.

## Patentansprüche

1. Verfahren zur Herstellung eines Substrats für einen nach vorne gerichteten Bildsensor, umfassend:
- die Bereitstellung eines Donatorsubstrats (30), eine zu übertragende Halbleiterschicht (3a) umfassend,
- die Bereitstellung eines Halbleiter-Trägersubstrats (1),
- die Verklebung des Donatorsubstrats (30) auf dem Trägersubstrat (1), wobei eine elektrisch isolierende Schicht (2) an der Verklebeschnittstelle ist,
- die Übertragung der Halbleiterschicht (3a) auf das Trägersubstrat (1),
und **dadurch gekennzeichnet, dass** das Verfahren ferner die Schritte umfasst, die bestehen, aus:
- der Implantierung von gasförmigen Ionen (40) in das Trägersubstrat (1) durch die übertragene Halbleiterschicht (3a) und die elektrisch isolierende Schicht (2) hindurch,
- nach der Implantierung, dem epitaxialen Wachstum einer zusätzlichen Halbleiterschicht (3b) auf der übertragenen Halbleiterschicht (3a).

2. Verfahren nach Anspruch 1, eine Wärmebehandlung umfassend, die bei einer Temperatur realisiert wird, die geeignet ist, um die Entwicklung von Hohlräumen ausgehend von den implantierten gasförmigen Ionen zu bewirken, wobei die Hohlräume eine Schicht (4) zum Einfangen von Metallatomen im Trägersubstrat (1) bilden.

3. Verfahren nach Anspruch 2, wobei die Wärmebehandlung während des epitaxialen Wachstums der zusätzlichen Halbleiterschicht (3b) durchgeführt wird.

4. Verfahren nach einem der Ansprüche 2 oder 3, wobei die Hohlraumdichte in der Einfangschicht (4) größer oder gleich 10¹⁵ Hohlräume/cm³ ist.

5. Verfahren nach einem der Ansprüche 1 bis 4, wobei jede Halbleiterschicht (3a, 3b) eine Siliziumschicht ist.

6. Verfahren nach einem der Ansprüche 1 bis 5, wobei die elektrisch isolierende Schicht (2) eine Siliziumoxidschicht ist.

7. Verfahren nach einem der Ansprüche 1 bis 6, wobei die elektrisch isolierende Schicht (2) aus einem Stapel (21, 22, 23) aus dielektrischen und/oder metallischen Materialien besteht.

8. Verfahren nach einem der Ansprüche 1 bis 7, wobei die elektrisch isolierende Schicht (2) eine Dicke zwischen 5 und 400 nm aufweist, vorzugsweise zwischen 30 und 150 nm.

9. Verfahren nach einem der Ansprüche 1 bis 8, wobei die gasförmigen Ionen (40) Helium-Ionen umfassen.

10. Verfahren nach einem der Ansprüche 1 bis 9, wobei die Übertragung der Halbleiterschicht (3a) umfasst:
- die Bildung einer Versprödungszone (31) im Donatorsubstrat, um die zu übertragende Halbleiterschicht abzugrenzen;
- nach der Verklebung, die Ablösung des Donatorsubstrats (30) entlang der Versprödungszone (31).

11. Verfahren zur Herstellung eines nach vorne gerichteten Bildsensors, die Herstellung eines Substrats nach dem Verfahren nach einem der Ansprüche 1 bis 10 umfassend, wobei die übertragene Halbleiterschicht (3a) und die zusätzliche Halbleiterschicht (3b) zusammen eine aktive Schicht des Bildsensors bilden, und die Bildung, in der aktiven Schicht, einer Vielzahl von elektrisch isolierenden Schneisen (5), um eine Vielzahl von Pixeln abzugrenzen.

## Claims

1. A process for fabricating a substrate for a front-side image sensor, comprising:
- providing a donor substrate (30) comprising a semiconductor layer (3a) to be transferred;
- providing a semiconductor support substrate (1);
- bonding the donor substrate (30) to the support substrate (1), an electrically insulating layer (2) being at the bonding interface;
- transferring the semiconductor layer (3a) to the support substrate (1);
- implanting gaseous ions (40) into the support substrate (1) through the transferred semiconductor layer (3a) and the electrically insulating layer (2);
- after said implantation, epitaxially growing an additional semiconductor layer (3b) on top of the transferred semiconductor layer (3a).

2. Process according to Claim 1, comprising a heat treatment carried out at a temperature adapted for causing cavities to develop from the implanted gaseous ions, said cavities forming a layer (4) for trapping metal atoms in the support substrate (1).

3. Process according to Claim 2, wherein said heat treatment is carried out during the epitaxial growth of the additional semiconductor layer (3b).

4. Process according to either of Claims 2 and 3, wherein the density of cavities in the trapping layer (4) is greater than or equal to 10¹⁵ cavities/cm³.

5. Process according to one of Claims 1 to 4, wherein each semiconductor layer (3a, 3b) is a silicon layer.

6. Process according to one of Claims 1 to 5, wherein the electrically insulating layer (2) is a silicon oxide layer.

7. Process according to one of Claims 1 to 6, wherein the electrically insulating layer (2) consists of a stack (21, 22, 23) of dielectric and/or metal materials.

8. Process according to one of Claims 1 to 7, wherein the thickness of the electrically insulating layer (2) is between 5 nm and 400 nm, and preferably between 30 nm and 150 nm.

9. Process according to one of Claims 1 to 8, wherein the gaseous ions (40) comprise helium ions.

10. Process according to one of Claims 1 to 9, wherein the transfer of the semiconductor layer (3a) comprises:
- forming a weakened zone (31) in the donor substrate in order to define said semiconductor layer to be transferred;
- after bonding, detaching the donor substrate (30) along the weakened zone (31).

11. Process for fabricating a front-side image sensor, comprising the fabrication of a substrate using the process according to one of Claims 1 to 10, the transferred semiconductor layer (3a) and the additional semiconductor layer (3b) together forming an active layer of said image sensor, and the formation, in said active layer, of a plurality of electrically isolating trenches (5) in order to define a plurality of pixels.
